Europäisches Patentamt

European Patent Office

Office européen des brevets

(19)

(11)     EP 0 332 784 B1

(12)                    EUROPEAN PATENT SPECIFICATION

(45) Date of publication and mention
of the grant of the patent:
**31.01.1996  Bulletin 1996/05**

(51) Int Cl.[6]: **G11B 5/72**, G11B 5/84,
**G11B 23/50, G11B 5/255,
G11B 5/712**

(21) Application number: **88311833.3**

(22) Date of filing: **14.12.1988**

(54) **A process of treating magnetic recording media**

Verfahren zur Behandlung von magnetischen Aufzeichnungsträgern

Procédé de traitement de supports d'enregistrement magnétiques

(84) Designated Contracting States:
**DE FR GB**

(30) Priority: **10.03.1988 US 166215**

(43) Date of publication of application:
**20.09.1989  Bulletin 1989/38**

(60) Divisional application: **95110702.8**

(73) Proprietor:
**SEAGATE TECHNOLOGY INTERNATIONAL
Georgetown, Grand Cayman Island (KY)**

(72) Inventors:
• **Brar, Amarjit Singh
Edina, Minnesota 55435 (US)**
• **Sharma, Jagdish Preseb
Bloomington, Minnesota 55438 (US)**

(74) Representative: **Kenyon, Sarah Elizabeth et al
London WC1R 4JH (GB)**

(56) References cited:
**EP-A- 0 248 556          EP-A- 0 249 216
US-A- 4 419 404          US-A- 4 549 238
US-A- 4 880 687          US-A- 5 069 967
US-A- 5 080 971**

• **IBM technical disclosure bulletin vol. 27, no.
10B, March 1985, Armonk NY (USA) page 6010
"Process for improving the lubricant retention
of magnetic storage disk"**
• **IBM technical disclosure bulletin vol. 25, no. 9,
February 1983, Armonk NY (USA) page 4550
M.Ko: "Method of plasma treatment on
magnetic coatings "**
• **PATENT ABSTRACTS OF JAPAN vol. 12, no.
144 (P-697)(2991) 6 May 1988 & JP-A-62- 264423**
• **PATENT ABSTRACTS OF JAPAN vol. 8, no. 257
(P-316)(1694) 24 November 1984 & JP-
A-59-127214**
• **John D. Roberts and Marjorie C. Caserio:
"BASIC PRINCIPLES OF ORGANIC
CHEMISTRY", second edition, 1977, W.A.
Benjamin, Inc., p.18**

## Description

This invention relates to processes for treating magnetic recording media for magnetic reading and recording transducers.

The employment of selected surface coatings and other treatments is a well known technique for enhancing the useful life and reliability of magnetic media and sliders of magnetic data reading and recording transducers. Magnetic discs and sliders are subject to wear on their interfaces or areas of mutual surface engagement as they are moved relative to one another. Even in disc drives employing "flying" heads which normally are separated from the disc by a thin air foil, surface contact during repeated starts and stops of disc rotation can cause substantial wear, and eventually lead to a head crash.

Accordingly, surfaces of sliders and discs frequently are treated to increase their toughness and strength, and to reduce friction. US-A-4,251,297 discloses a boronised layer formed on the surface portion of a slider disposed to contact a magnetic recording medium. US-A-4,631,614 discloses a plasma process for improving saturation magnetisation of a transducer. In particular, a gap spacer material and a pole piece are deposited using an Alfesil target along with either argon or nitrogen gas.

In connection with a device in which the slider is normally in contact with a magnetic tape or disc, a technique to improve the slidability between the tape or disc and the slider is disclosed in US-A-4,649,488. The sliding surface of the slider is coated with zirconium oxide or other material having a high co-efficient of thermal expansion, in particular high enough to carbonise the binder of the recording medium.

US-A-4,619,861 discloses a plasma polymerisation technique for coating the particles which make up magnetic powders. The technique is said to improve the dispersability, squareness ratio and dusting of the magnetic powders.

Another known approach is to provide a passivation layer of sputtered carbon over the magnetic media or recording layer of a disc, both to protect the media layer against corrosion and to improve surface lubricity. An example of which can be found in EP-A-249 216. This carbon overcoat is quite thin, typically in the range of 300 to 400 Angstroms, and, as formed, includes micro-pores and sometimes "pinholes" exposing a recording layer. Another problem encountered with carbon overcoat is a build-up of debris, principally carbon particles, on the surface of the disc. The slider, due to high surface energy, tends to pick up this debris, leading ultimately to a head crash.

Patent Abstracts of Japan Vol. 12, Number 144 (p-697)[2991] 6, May 1988, discloses a magnetic recording medium comprising an underlying film layer, a nonmagnetic metallic protective film, a carbon protective film and the top coat film on a nonmagnetic substrate. The top coat film is formed of a plasma-polyerized film.

The present invention seeks to improve the lubricity, smoothness and wear characteristics in a carbon layer provided over a magnetic media layer of a magnetic disc or other medium.

Furthermore, the present invention seeks to provide magnetic media having reduced friction at their interface, thereby to reduce noise due to friction and increase signal quality.

According to one aspect of the present invention, there is provided a process for treating a carbon layer on a magnetic recording medium including the steps of:

enclosing the magnetic recording medium within a chamber, said medium including a substrate, a recording layer of magnetisable material formed over the substrate, and the carbon layer over the recording layer;
generating and maintaining within said chamber an inert gas plasma at a pressure substantially less than atmospheric pressure and for an amount of time necessary substantially to clean exposed surface areas of said carbon layer thereby reducing porosity and roughness of said carbon layer; then
generating and maintaining within the chamber a plasma mixture at a selected pressure substantially less than atmospheric pressure wherein, said plasma mixture consists essentially of a reactive gas; characterised in that said plasma mixture is maintained at a selected temperature and for a selected time sufficient for the inert gas to etch surface peaks of the carbon layer thereby improving the smoothness of the carbon layer;
in that said plasma mixture further consists essentially of an inert gas comprising at least 15% by volume of the plasma mixture; and
in that said reactive gas comprises at least 60% by volume of the mixture and includes means for fluorinating at least a portion of said carbon layer, said means consisting only of fluorine, so as to form extended chain fluoropolymers with the exposed carbon layer.

As a result of this process, the carbon layer of the treated medium becomes fluorinated, at least along its exposed surfaces. In particular, the reactive component of the plasma mixture combines with the carbon to form extended chain fluoropolymers, believed to include one or more of the following constituents:
hexafluoroethane, tetrafluoroethylene and tetrafluoropropylene. These constituents form a solid lubricant over the exposed surfaces of the carbon layer, and strengthen the surfaces due to their bonding characteristics.

The fluorinating step further substantially enhances surface smoothness of the carbon layer, by a combined etching of surface peaks by argon ions or other inert components of the mixture, together with implantation of carbon and fluorine ions within the micro-pores, defects, valleys and adjoining molecules of the surface. The ion implantation, together with the formation of extended chain fluoropolymers, substantially enhances the strength and toughness of the carbon layer and enhances its elasticity, resulting in better damping characteristics.

The reactive gas may comprise from 75% to 85%, preferably 80%, of the mixture.

Said selected time may be approximately 25 to 30 minutes.

The cleaning or etching may be carried out at room temperature or about 100°C.

The selected temperature may be room temperature or about 100°C.

Other aspects of the invention are set out in the appended claims and include a magnetic recording medium subject to a process as claimed in one or other of the first and second aspects of the present invention.

The invention is illustrated, merely by way of example, in the accompanying drawings, in which:-

Figure 1 is a sectional view of part of a magnetic data storage disc provided with a known carbon overcoat;
Figure 2 is an enlarged partial view of Figure 1;
Figure 3 is a schematic representation of a plasma treatment apparatus for carrying out a process according to the present invention;
Figure 4 is a sectional view of the magnetic medium in Figure 1, after treatment by a process according to the present invention; and
Figure 5 is an enlarged partial view of Figure 4.

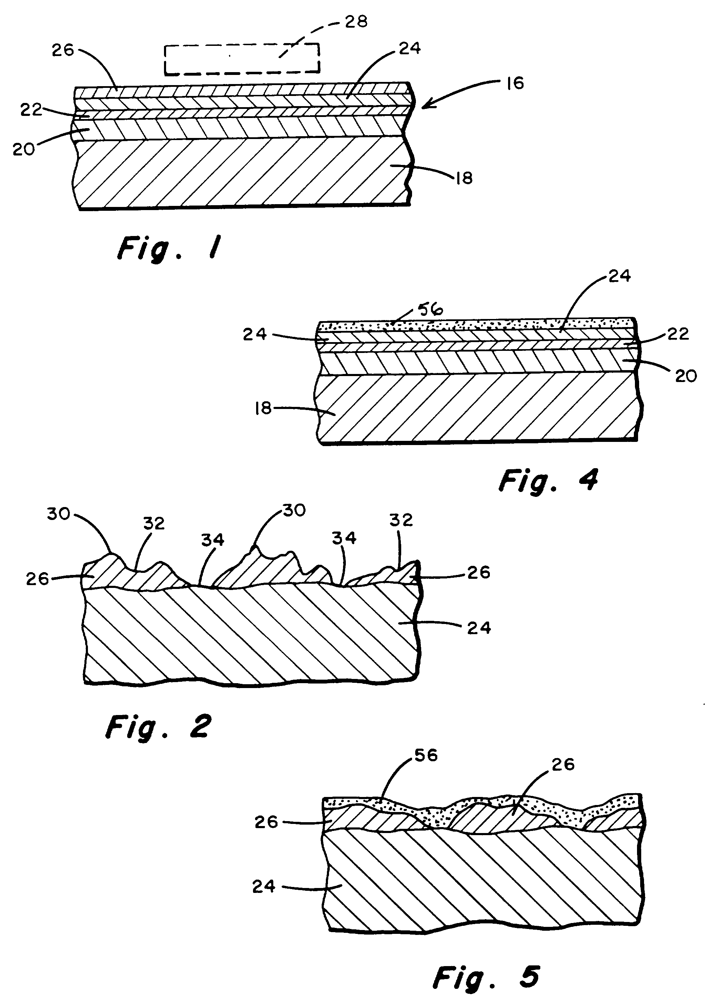

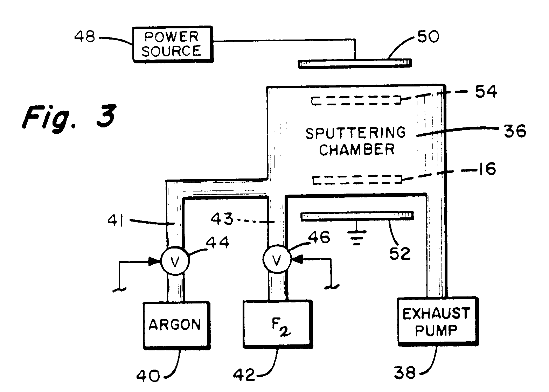

Turning now to the drawings, there is shown in Figure 1 a section of a magnetic data storage disc 16, formed by selectively layering a substrate 18 preferably formed of aluminium. A layer 20 consists of nickel, plated on the substrate 18 by an electroless process. The layer 20 has a high degree of surface roughness and therefore is polished to a thickness of approximately 0.01 mm ($10^5$ Angstrom - 400 micro-inch). Next, a layer 22 of chromium is deposited on the layer 20 by sputtering, to a thickness of about $10^{-6}$mm (10 Angstroms). A recording layer 24 then is sputtered onto the layer 22, to a thickness of about $2 \times 10^{-5}$ to $3 \times 10^{-5}$ mm (200 to 300 Angstroms). The recording layer 24 is formed on a magnetisable material, typically nickel/iron or nickel/cobalt alloy, which also may include chrome. In lieu of sputtering, the recording layer 24 in some cases may be formed by plating. Finally, a carbon layer 26 having a thickness of about $3 \times 10^{-5}$ to $4 \times 10^{-5}$ mm (300 to 400 Angstroms) is deposited onto the recording layer by sputtering.

The carbon layer 26 is provided to protect the recording layer against corrosion, and also to provide lubricity, thereby to reduce friction between the disc 16 and the slider 28 of a magnetic data transducing head. The slider 28 is shown in its normal operating position, supported approximately $2.5 \times 10^{-4}$ mm (10 micro-inch) above the disc by an air foil generated by disc rotation.

Thus, whilst surface contact friction is not present during operation, repeated starting and stopping of the disc involves contact between the slider and disc, such that friction can damage the slider 28, the disc 16 or both.

In addition to providing corrosion protection and lubrication, the carbon layer 26 should be as smooth as possible to provide the desired narrow air foil or flying height. The utility of a data storage system employing the disc 16 and the slider 28 resides largely in the density of data storage. Generally, density increases as the gap between the slider 28 and the recording layer 24 is reduced. Therefore, it is advantageous to minimise the thickness of the carbon layer 26 as well as the flying height.

As seen from the enlarged view in Figure 2 showing only the layers 24, 26, the carbon layer 26 is not smooth but has numerous peaks 30, depressions or valleys 32, and pinholes 34 which leave the recording layer 24 exposed to damage, particularly due to moisture. Depositing a sufficient thickness of carbon to remove the pinholes 34 increases the thickness of the carbon layer 26 and therefore undesirably enlarges the gap between the slider and the recording layer 24. Of course, the flying height of the slider 28 must be sufficient to avoid peaks, and therefore the effective thickness of the carbon layer 26 is equal to the height of the peaks.

The surface roughness of the carbon layer 26 contributes to the friction between the disc and the slider. Furthermore, the carbon layer, particularly at peaks 30, is susceptible to fretting or fracturing from contact between the slider and the disc. The result is a build-up of debris consisting mainly of carbon particles, which are picked up by the slider. Build-up of such debris on the slider eventually leads to a head crash.

To smooth and toughen the carbon layer 26 and to improve its lubricity, the disc 16 is treated with a plasma treating apparatus including a fluid tight plasma chamber 36 schematically illustrated in Figure 3 for carrying out a process according to the present invention. While just one disc 16 is shown in the chamber 36, it is to be understood that the chamber 36 can be of a sufficient size to accommodate many discs.

The apparatus includes an exhaust pump 38 in fluid communication with the chamber 36 for evacuating the chamber when desired. Also in fluid communication with the chamber, through lines 41 and 43 respectively, are first and second containers 40, 42. Containers 40, 42 respectively comprise a supply of an inert gas such as argon, and a reactive gas, fluorine ($F_2$). Valves 44, 46 control, respectively, the supply of argon and reactive gas to the chamber. A power supply 48 biases an electrode 50 with respect to a grounded electrode 52 to generate an electric field necessary to ionise gas contained in the chamber 36.

To treat the disc 16, the exhaust pump 38 is actuated to substantially evacuate the chamber 36. After evacuation, the valve 44 is opened to supply argon to the chamber, with none of the reactive gas being supplied at this point. Argon is supplied to the chamber until pressure within the chamber is about 33 Pa (250 millitorr). Then, power at 600 watts is supplied to the electrode 50 to generate an electric field and ionise the argon, forming an argon plasma within the chamber 36. Etching/cleaning proceeds at a temperature of about 100°C commonly referred to as low temperature plasma.

The argon plasma is maintained in the chamber 36 for approximately 10 minutes, depending upon the load. The argon plasma cleans and etches the exposed surface of the carbon layer 26, particularly in removing or diminishing the peaks 30. This etching process, however, has the undesirable effect of increasing the surface energy of the carbon layer.

The disc 16 is then subject to a further plasma process. The chamber 36 again is evacuated, whereupon valves 44, 46 an opened to permit a mixture of argon and reactive gas to enter the chamber. Valves 44, 46 are controlled in the comparative lengths of time for which they are opened, to provide a mixture which is at least 60% by volume, of reactive gas. Preferably the percentage of reactive gas is in the range of 75% to 85% by volume, with a particularly preferred mixture being 80% reactive gas and 20% argon. The argon and reactive gas are permitted to enter the chamber 36 until the pressure within the chamber is in the range of from 27 Pa to 54 Pa (200 to 400 millitorr), and preferably about 47 Pa (350 millitorr). In general, higher pressure enhances ion penetration, while lower pressure improves plasma flow. Power at 600 watts is supplied to the electrode 50 and the plasma process proceeds at approximately 100°C. The preferred exposure time has been found to be 25 to 30 minutes, depending upon the area of the disc and materials.

During this treatment, conditions inside the chamber 36 become increasingly favourable for reactions of the fluorine ions with carbon, thus to form extended chain fluoropolymers along and beneath exposed surfaces of the carbon layer 26. In particular, one or more of the following reactions is believed to occur:

$$6CF_4 + 2C \rightarrow 4C_2F_6$$

$$CF_4 + C \rightarrow C_2F_4$$

$$2CF_4 + 4C \rightarrow 2C_3F_4$$

Thus, one or more of the above fluoropolymers, namely hexafluoroethane, tetrafluoroethylene and tetrafluoropropylene are believed to be formed over the surface of the carbon layer, and into the carbon layer to a depth which increases with the time of exposure in the plasma chamber. In effect, at least a portion of the carbon layer is fluorinated, with that portion of the carbon layer being altered to a thin film of carbon and extended chain fluoropolymers.

Due to the superior bonding strength of the extended chain fluoropolymers, the fluorinated carbon film has a greater surface fatigue and fretting strength than the untreated carbon layer. Further, the fluorinated carbon film reduces slider/disc friction due to improved lubricity, as these polymers act as solid lubricants.

In addition to their part in forming extended chain fluoropolymers, carbon and fluorine ions generated during the plasma process become implanted in the carbon layer, particularly in micro-pores, defects, valleys 32 and pinholes 34, thus filling in the pinholes to provide positive protection against moisture penetration. In combination with the etching action of the argon in removing or reducing the peaks 30, this ion implanting thus tends to smooth the surface of the carbon layer 26. Yet another benefit of the combined ion implantation and reaction product is a lower surface energy of the carbon layer 26, thus reducing the chance of surface contamination, enhancing surface lubricity and preventing corrosion.

A segment of the disc 16 after treatment is shown in Figure 4, and in greater detail in Figure 5. While much of the carbon layer 26 remains in its original form, a fluorinated carbon film 56 has formed which consists of carbon and the above mentioned extended chain fluoropolymers. Asperities or peaks in the original carbon layer have been reduced or removed by the argon etching, while the micro-pores, defects, valleys and pinholes have been at least partially filled by the implantation of ions. Consequently, the carbon layer 26 as treated is substantially smoother than the original carbon layer. The overall surface energy is reduced, as the ion implantation and the reaction product film on the surface reduces surface energy and overcomes the tendency of argon etching to increase the surface energy. The increasing smoothness of course further reduces friction. The accompanying reduction of noise due to friction enhances the signal generated in the transducing head, in particular, the signal to noise ratio. Due to the nature of the bonding of the fluoropolymers, the elasticity and damping characteristics of the surface are also improved.

## Claims

1. A process for treating a carbon layer on a magnetic recording medium including the steps of:

enclosing the magnetic recording medium within a chamber (36), said medium including a substrate (18), a recording layer (24) of magnetisable material formed over the substrate, and the carbon layer (26) over the recording layer; generating and maintaining within said chamber (36) an inert gas plasma at a pressure substantially less than atmospheric pressure and for an amount of time necessary substantially to clean exposed surface areas of said carbon layer (26) thereby reducing porosity and roughness of said carbon layer; then generating and maintaining within the chamber (36) a plasma mixture at a selected pressure substantially less than atmospheric pressure wherein, said plasma mixture consists essentially of a reactive gas; characterised in that said plasma mixture is maintained at a selected temperature and for a selected time sufficient for the inert gas to etch surface peaks of the carbon layer thereby improving the smoothness of the carbon layer;

in that said plasma mixture further consists essentially of an inert gas comprising at least 15% by volume of the plasma mixture; and

in that said reactive gas comprises at least 60% by volume of the mixture and includes means for fluorinating at least a portion of said carbon layer (26), said means consisting only of fluorine, so as to form extended chain fluoropolymers with the exposed carbon layer.

2. A process as claimed in claim 1, in which said inert gas is argon.

3. A process as claimed in any preceding claim, in which the reactive gas comprises from 75% to 85% of said mixture.

4. A process as claimed in any preceding claim, in which the reactive gas comprises 80% of said mixture.

5. A process as claimed in any preceding claim, in which said selected pressure is in the range of from 27 Pa to 54 Pa (200 to 400 millitorr).

6. A process as claimed in any preceding claim, in which said selected time is approximately 25 to 30 minutes.

7. A process as claimed in any preceding claim, in which the cleaning or etching is carried out at room temperature.

8. A process as claimed in any of claims 1 to 6, in which the cleaning or etching is carried out at about 100°C.

9. A process as claimed in any preceding claim, in which the selected temperature is room temperature .

10. A process as claimed in any of claims 1 to 8, in which the selected temperature is about out 100°C.

11. A magnetic recording medium subject to a process as claimed in any of claims 1 to 10, in which said extended chain fluoropolymers include one or more of the following constituents: hexafluoroethane, tetrafluoroethylene, tetrafluoropropylene.

12. A medium as claimed in claim 11, further comprising a layer (20) constituting essentially of nickel formed over said substrate (18) and between said substrate and said recording layer (24), and a layer of chrome (22) between said nickel layer (20) and said recording layer (24).

**Patentansprüche**

1. Verfahren zur Behandlung einer Kohlenstoffschicht auf einem magnetischen Aufzeichnungsträger mit den folgenden Schritten:

Einschließen des magnetischen Aufzeichnungsträgers in einer Kammer (36), wobei der Aufzeichnungsträger ein Substrat (18), eine Aufzeichnungsschicht (24) aus magnetisierbarem Material, das über dem Substrat ausgebildet ist, und die Kohlenstoffschicht (26) über der Aufzeichnungsschicht einschließt,

Erzeugen und Aufrechterhalten eines inerten Gasplasmas in der Kammer (36) mit einem Druck, der wesentlich kleiner als atmosphärischer Druck ist, und über eine Zeitdauer, die erforderlich ist, um Oberflächenbereiche der Kohlenstoffschicht (26) im wesentlichen zu reinigen, wodurch die Porösität und die Rauhigkeit der Kohlenstoffschicht verringert wird, dann

Erzeugen und Aufrechterhalten einer Plasmamischung in der Kammer (36) mit einem ausgewählten Druck, der beträchtlich kleiner als der atmosphärische Druck ist, wobei die Plasmamischung wesentlich aus einem reaktiven Gas besteht, dadurch gekennzeichnet, daß die Plasmamischung auf einer ausgewählten Temperatur und über eine ausgewählte Zeit gehalten wird, die ausreicht, damit das inerte Gas Oberflächenspitzen der Kohlenstoffschicht fortätzt, wodurch die Glätte der Kohlenstoffschicht verbessert wird,

daß die Plasmamischung weiterhin wesentlich aus einem inerten Gas besteht, das zumindest 15 Volumenprozent der Plasmamischung bildet, und

daß das reaktive Gas zumindest 60 Volumenprozent der Mischung bildet und Mittel zur Fluorierung zumindestens eines Teils der Kohlenstoffschicht (26) einschließt, wobei diese Mittel lediglich aus Fluor bestehen, so daß langgestreckte Ketten aufweisende Fluor-Polymere mit der freiliegenden Kohlenstoffschicht gebildet werden.

2. Verfahren nach Anspruch 1, dadurch gekennzeichnet, daß das inerte Gas Argon ist.

3. Verfahren nach einem der vorhergehenden Ansprüche, bei dem das reaktive Gas von 75% bis 85% der Mischung bildet.

**4.** Verfahren nach einem der vorhergehenden Ansprüche, bei dem das reaktive Gas 80% der Mischung bildet.

**5.** Verfahren nach einem der vorhergehenden Ansprüche, bei dem der ausgewählte Druck im Bereich von 27 Pa bis 54 Pa (200 bis 400 Millitorr) liegt.

**6.** Verfahren nach einem der vorhergehenden Ansprüche, bei dem die ausgewählte Zeit ungefähr 25 bis 30 Minuten beträgt.

**7.** Verfahren nach einem der vorhergehenden Ansprüche, bei dem die Reinigung oder das Ätzen bei Raumtemperatur ausgeführt wird.

**8.** Verfahren nach einem der Ansprüche 1 bis 6, bei dem die Reinigung oder das Ätzen bei ungefähr 100°C ausgeführt wird.

**9.** Verfahren nach einem der vorhergehenden Ansprüche, bei dem die ausgewählte Temperatur Raumtemperatur ist.

**10.** Verfahren nach einem der Ansprüche 1 bis 8, bei dem die ausgewählte Temperatur ungefähr 100°C beträgt.

**11.** Magnetischer Aufzeichnungsträger, der einem Verfahren nach einem der Ansprüche 1 bis 10 unterworfen wird, bei dem die langgestreckte Ketten aufweisenden Fluorpolymere ein oder mehrere der folgenden Bestandteile einschließen: Hexafluoräthan, Tetrafluoräthylen, Tetrafluorpropylen.

**12.** Aufzeichnungsträger nach Anspruch 11, der weiterhin eine Schicht (20), die im wesentlichen aus Nickel besteht und über dem Substrat (18) und zwischen dem Substrat und der Aufzeichnungsschicht (24) ausgebildet ist, und eine Schicht aus Chrom (22) zwischen der Nickelschicht (20) und der Aufzeichnungsschicht (24) umfaßt.

**Revendications**

**1.** Processus pour traiter une couche de carbone sur un support d'enregistrement magnétique comprenant les étapes suivantes :

l'enfermement du support d'enregistrement magnétique à l'intérieur d'une chambre (36), ledit support comprenant un substrat (18), une couche d'enregistrement (24) d'une matière pouvant être magnétisée formée sur le substrat, et la couche de carbone (26) sur la couche d'enregistrement ;

la production et le maintien à l'intérieur de ladite chambre (36) d'un plasma de gaz inerte à une pression sensiblement inférieure à la pression atmosphérique et pendant une période de temps sensiblement nécessaire pour nettoyer les zones de surface exposées de ladite couche de carbone (26), réduisant, de ce fait, la porosité et la rugosité de ladite couche de carbone ; puis la production et le maintien à l'intérieur de la chambre (36) d'un mélange de plasma à une pression sélectionnée sensiblement inférieure à la pression atmosphérique, dans lequel ledit mélange de plasma est constitué principalement d'un gaz réactif ; caractérisé en ce que ledit mélange de plasma est maintenu à une température sélectionnée et pendant un temps sélectionné, suffisant pour que le gaz inerte attaque les pics de surface de la couche de carbone, améliorant, de ce fait, le lissé de la couche de carbone ;

en ce que ledit mélange de plasma est constitué, de plus, principalement d'un gaz inerte comprenant au moins 15 % en volume du mélange de plasma ; et

en ce que ledit gaz réactif est constitué d'au moins 60 % en volume du mélange et comprend un moyen pour fluorer au moins une partie de ladite couche de carbone (26), ledit moyen étant seulement constitué de fluor, de façon à former des fluoropolymères à chaîne étendue avec la couche de carbone exposée.

**2.** Processus selon la revendication 1, dans lequel ledit gaz inerte est de l'argon.

**3.** Processus selon l'une quelconque des revendications précédentes, dans lequel le gaz réactif comprend de 75 % à 85 % dudit mélange.

**4.** Processus selon l'une quelconque des revendications précédentes, dans lequel le gaz réactif comprend 80 % dudit mélange.

**5.** Processus selon l'une quelconque des revendications précédentes, dans lequel ladite pression sélectionnée est dans la plage de 27 Pa à 54 Pa (200 à 400 millitorr).

**6.** Processus selon l'une quelconque des revendications précédentes, dans lequel ledit temps sélectionné est de 25 à 30 minutes environ.

**7.** Processus selon l'une quelconque des revendications précédentes, dans lequel le nettoyage ou l'attaque sont exécutés à température ambiante.

**8.** Processus selon l'une quelconque des revendications 1 à 6, dans lequel le nettoyage ou l'attaque sont exécutés à 100°C environ.

9. Processus selon l'une quelconque des revendications précédentes, dans lequel la température sélectionnée est la température ambiante.

10. Processus selon l'une quelconque des revendications 1 à 8, dans lequel la température sélectionnée est de 100°C environ.

11. Support d'enregistrement magnétique soumis à un processus selon l'une quelconque des revendications 1 à 10, dans lequel lesdits fluropolymères à chaîne étendue comprennent un ou plusieurs des éléments suivants : hexafluoroéthane, tétrafluoroéthylène et tétrafluoropropylène.

12. Support selon la revendication 11, comprenant, de plus, une couche (20) constituée principalement de nickel formée sur ledit substrat (18) et entre ledit substrat et ladite couche d'enregistrement (24), et une couche de chrome (22) entre ladite couche de nickel (20) et ladite couche d'enregistrement (24).

Fig. 1

Fig. 4

Fig. 2

Fig. 5

**Fig. 3**